# EUROPÄISCHE PATENTANMELDUNG

(11) **EP 1 028 321 A2**
(43) Veröffentlichungstag der Anmeldung: **16.08.2000**
(21) Anmeldenummer: 00102312.6
(22) Anmeldetag: 03.02.2000
(51) Int. Cl.: G01R 15/04

(54) **Stromteiler für Messwandler**

(30) Priorität: 09.02.1999 DE 19905118
(71) Anmelder: Heilmann, Michael, 18442 Negast (DE); Walljan, Martin, 18510 Abshagen (DE)
(72) Erfinder: Heilmann, Michael, 18442 Negast (DE); Walljan, Martin, 18510 Abshagen (DE)
(74) Vertreter: Schnick, Achim

(57) **Zusammenfassung**

Die Erfindung betrifft einen Stromteiler für die Erzeugung proportionaler Teilströme, insbesondere Meßstromteiler.

Der Stromteiler besteht aus einem Hauptstromleiter, der einen mit einem Feldsensor ausgestatteten Nebenstromleiter umgibt. Der Hauptstromleiter ist in seinem senkrecht zur Stromrichtung liegenden Querschnitt radialsymmetrisch ausgebildet. Der Hauptstromleiter und der Nebenstromleiter sind sowohl an der Stromeintrittsseite des Stromteilers als auch an dessen Stromaustrittsseite elektrisch leitfähig miteinander verbunden und weisen an diesen Stellen Anschlußkontakte zum Zu- und Abführen des zu messenden Stromes auf.

Dabei wird der Effekt ausgenutzt, daß innerhalb eines stromdurchflossenen rohrförmigen, oder radialsymmetrisch angeordneten mehrteiligen Leiters das elektromagnetische Feld kompensiert ist. Im so entstandenen feldfreien Raum ist die Beeinflussung des Feldsensors durch das Feld des Hauptstromleiters ausgeschlossen. Mit sehr großer Genauigkeit wird nur das Feld des Nebenstromleiters erfaßt. Außerdem ist durch die Anordnung des Nebenstromleiters im Hauptstromleiter naturgemäß ein hervorragender Temperaturausgleich gegeben.

## Beschreibung

Die Erfindung betrifft einen Stromteiler für die Erzeugung proportionaler Teilströme, insbesondere Meßstromteiler.

In der Energiewirtschaft müssen elektrische Ströme sowohl aus technischen Gründen - zum Steuern, Verriegeln (Schützen) und Regeln - , als auch aus betriebswirtschaftlichen und kommerziellen Gründen - zum Festlegen des Betriebsregimes und für den Handel mit Elektroenergie - gemessen werden.

Die in der Energiewirtschaft vorkommenden großen Ströme können ohne großen Aufwand nicht direkt gemessen werden. Die auswertenden Geräte (Anzeigegeräte, Registriergeräte, Schutzrelais, Grenzwertschalter und Energiezähler), können nur geringe Ströme oder andere analoge Signale verarbeiten. Dem Stand der Technik entsprechend wird dieses Problem gelöst, indem nicht der Strom direkt, sondern das elektromagnetische Feld um den stromdurchflossenen Leiter gemessen wird. Zu diesem Zweck werden Feldsensoren eingesetzt, die das elektromagnetische Feld erfassen und in eine verwertbare physikalische Größe umwandeln. Hier wurde eine Vielzahl unterschiedlicher Sensoren entwickelt. An dieser Stelle seien nur die Ringkernspule, die Rogowski-Spule und das Hall-Element genannt. Die konstruktive Einheit von stromführendem Leiter und Feldsensor wird als Meßwandler, in der Energiewirtschaft als Stromwandler oder nur Wandler bezeichnet.

Der wesentliche Nachteil, der alle diese Meßwandler kennzeichnet, besteht darin, daß die räumliche und elektrische Dimensionierung auf den höchsten zu messenden Leiterstrom abgestimmt sein muß. Dadurch entstehen große, unhandliche Wandler, deren Herstellung durch einen hohen Material- und Fertigungsaufwand teuer ist und die am Einbauort in der elektrotechnischen Anlage viel Platz beanspruchen. Zum Beispiel besitzen die in US 5,541,503, US 5,416,408, DE 19542899 A1 und DE 19614973 A1 vorgeschlagenen Meßwandler und alle dort genannten Ausführungsbeispiele die vorgenannten Unzulänglichkeiten.

Diese Nachteile wurden in DE 30 08 308 A1 bereits erkannt und ein Stromteiler für Meßwandler vorgeschlagen, der es ermöglicht, nur einen Teil des zu messenden Leiterstromes zu erfassen. Erreicht wird das, indem der Strom durch drei elektrisch parallel angeordnete Leiter geführt wird. Zwei davon, die Hauptstromleiter, besitzen einen geringen elektrischen Widerstand und führen den Hauptanteil des zu messenden Gesamtstromes, der dritte (Nebenstromleiter) besitzt einen größeren elektrischen Widerstand, führt einen zum Gesamtstrom proportionalen Teilstrom und ist mit einem Feldsensor versehen. Der so entstandene Wandler (Nebenstromleiter und Feldsensor) kann kleiner und weniger aufwendig ausgeführt werden. Der entscheidende Nachteil dieser in DE 30 08 308 beschriebenen Bauweise des Stromteilers liegt darin, daß das elektromagnetische Streufeld der Hauptstromleiter auf Grund ihrer Geometrie nur unzureichend kompensiert werden kann, wodurch der Feldsensor, der sich auf dem Nebenstromleiter befindet, derart beeinflußt wird, daß der Meßwert verfälscht wird. Außerdem sind die Hauptstromleiter und Nebenstromleiter räumlich voneinander getrennt angeordnet, so daß kein Temperaturausgleich möglich ist. Bei einseitiger Wärmeeinwirkung auf den Stromteiler (andere Anlagenteile, Sonne oder Zugluft) ändert sich das Stromteilungsverhältnis, wodurch das Ausgangssignal des Feldsensors verfälscht wird.

Der Erfindung liegt die Aufgabe zugrunde, einen einfachen und kostengünstigen Stromteiler mit sehr geringem Meßfehler zu schaffen, der die vorgenannten Nachteile beseitigt.

Erfindungsgemäß wird die Aufgabe durch die Merkmale des Hauptanspruches 1 gelöst. Die Merkmale der Unteransprüche definieren Ausführungsformen und Varianten der Erfindung.

Der Stromteiler gemäß dem Hauptanspruch besteht aus einem Hauptstromleiter, der einen mit einem Feldsensor ausgestatteten Nebenstromleiter umgibt. Der Hauptstromleiter ist in seinem senkrecht zur Stromrichtung liegenden Querschnitt radialsymmetrisch ausgebildet. Der Hauptstromleiter und der Nebenstromleiter sind sowohl an der Stromeintrittsseite des Stromteilers als auch an dessen Stromaustrittsseite elektrisch leitfähig miteinander verbunden und weisen an diesen Stellen Anschlußkontakte zum Zu- und Abführen des zu messenden Stromes auf.

Dabei wird der Effekt ausgenutzt, daß innerhalb eines stromdurchflossenen rohrförmigen, oder radialsymmetrisch angeordneten mehrteiligen Leiters das elektromagnetische Feld kompensiert ist. Im so entstandenen feldfreien Raum ist die Beeinflussung des Feldsensors durch das Feld des Hauptstromleiters ausgeschlossen. Mit sehr großer Genauigkeit wird nur das Feld des Nebenstromleiters erfaßt. Außerdem ist durch die Anordnung des Nebenstromleiters im Hauptstromleiter naturgemäß ein hervorragender Temperaturausgleich gegeben.

Die Erfindung wird anhand eines Ausführungsbeispiels näher beschrieben. Die dazugehörigen Zeichnungen zeigen in
- Fig. 1: eine längsgeschnittene Darstellung einer ersten Ausführungsform des erfindungsgemäßen Stromteilers,
- Fig. 2: eine längsgeschnittene Darstellung einer zweiten Ausführungsform des Stromteilers, bei dem die einzelnen Elemente mittels Schrumpfen und Pressen zusammengefügt sind,
- Fig. 3: eine längsgeschnittene Darstellung einer dritten Ausführungsform des Stromteilers, bei dem die einzelnen Elemente mittels Schweißen zusammengefügt sind,
- Fig. 4: eine längsgeschnittene Darstellung einer vierten Ausführungsform des Stromteilers, bei dem die einzelnen Elemente mittels Schrauben zusammengefügt sind,
- Fig. 5: eine Seitenansicht zu Fig. 4,
- Fig. 6: eine auseinandergezogene Darstellung einer fünften Ausführungsform des Stromteilers,
- Fig. 7: eine räumliche Darstellung einer sechsten Ausführungsform des Stromteilers,
- Fig. 8: eine räumliche Darstellung einer siebenten Ausführungsform des Stromteilers,
- Fig. 9: eine längsgeschnittene Darstellung einer mit Isoliermaterial umhüllten Ausführungsform des Stromteilers,
- Fig. 10: eine längsgeschnittene Darstellung einer mit Isoliermaterial ausgefüllten Ausführungsform des Stromteilers,
- Fig. 11: eine längsgeschnittene Darstellung einer gegen äußere Magnetfelder abgeschirmten Ausführungsform des Stromteilers,
- Fig. 12: eine Darstellung einer Ausführungsform des Stromteilers mit als Ringkemspule ausgebildetem Feldsensor,
- Fig. 13: eine Darstellung einer Ausführungsform des Stromteilers mit einem Feldsensor, der aus mehreren Primärwicklungen gebildet wird,
- Fig. 14: eine Darstellung einer Ausführungsform des Stromteilers mit als Rogowski-Spule ausgebildetem Feldsensor,
- Fig. 15: eine Darstellung einer Ausführungsform des Stromteilers, mit der das Meßprinzip als Nullflußwandler realisiert wird,
- Fig. 16: das Schaltschema der Ausführungsform gemäß Fig. 15,
- Fig. 17: eine Darstellung einer Ausführungsform des Stromteilers, mit der das Meßprinzip als Allfrequenz-Stromwandler realisiert wird,
- Fig. 18: das Schaltschema der Ausführungsform gemäß Fig. 17,
- Fig. 19: eine Darstellung einer Ausführungsform des Stromteilers, mit der das Meßprinzip als Hallelement realisiert wird,
- Fig. 20: eine Darstellung einer Ausführungsform des Stromteilers, bei der eine potentialfreie Auskopplung über LWL erfolgt,
- Fig. 21: eine Darstellung einer Ausführungsform des Stromteilers, bei der eine potentialfreie Auskopplung und Energieversorgung über LWL erfolgt,
- Fig. 22: eine Darstellung einer Ausführungsform des Stromteilers als Handmeßgerät mit Analoganzeige,
- Fig. 23: eine Darstellung einer Ausführungsform des Stromteilers als Handmeßgerät mit Digitalanzeige,
- Fig. 24: eine räumliche Darstellung einer achten Ausführungsform des Stromteilers,
- Fig. 25: eine räumliche Darstellung einer neunten Ausführungsform des Stromteilers.

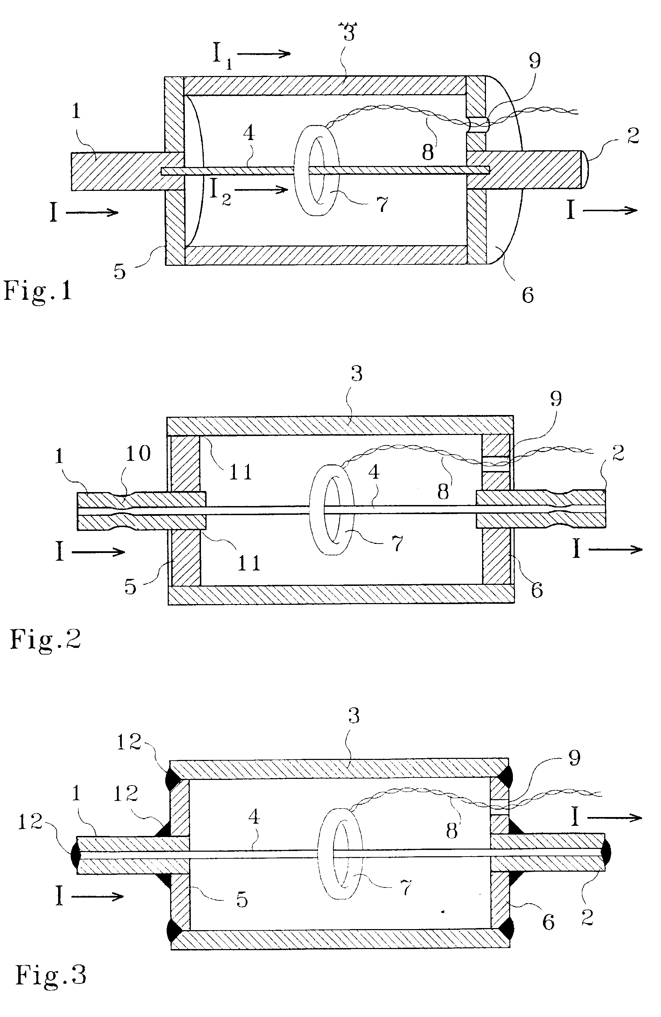

Fig.1 zeigt den Stromteiler im Längsschnitt. Der Stromteiler wird an den Anschlüssen 1 und 2 in den Stromkreis mit dem zu messenden Strom I eingebunden. Beim Durchfließen des Stromteilers teilt sich der Strom I im umgekehrten Verhältnis des Widerstandes des Hauptstromleiter 3 zum Widerstand des Nebenstromleiters 4 in I₁ im rohrförmigen Hauptstromleiter 3 und in I₂ im Nebenstromleiter 4 auf. Das elektromagnetische Feld des Nebenstromleiters 4 wird vom Feldsensor 7 erfaßt, der auf Grund des fehlenden Streufeldes des Hauptstromleiters 3 ein unverfälschtes Signal liefen, das sich proportional zum Strom I₂ im Nebenstromleiter 4 und somit auch zum Gesamtstrom I verhält. Damit die Homogenität des sich selbst kompensierenden Feldes des Hauptstromleiters 3 im Bereich des Feldsensors 7 nicht gestört wird, wird die Bohrung 9 für die Signalleitungen 8 des Feldsensors 7 in einer Stirnseite des Stromteilers - Kontaktplatte 6 - angebracht.

Die Anschlüsse 1 und 2, der Hauptstromleiter 3, der Nebenstromleiter 4 und Kontaktplatten 5 und 6 bestehen aus leitfähigem Material, vorzugsweise Kupfer oder Aluminium, und sind mit bekannten Methoden beispielsweise Hart- oder Weichlöten, Schweißen, Schrauben, Pressen oder Schrumpfen zusammengefügt.

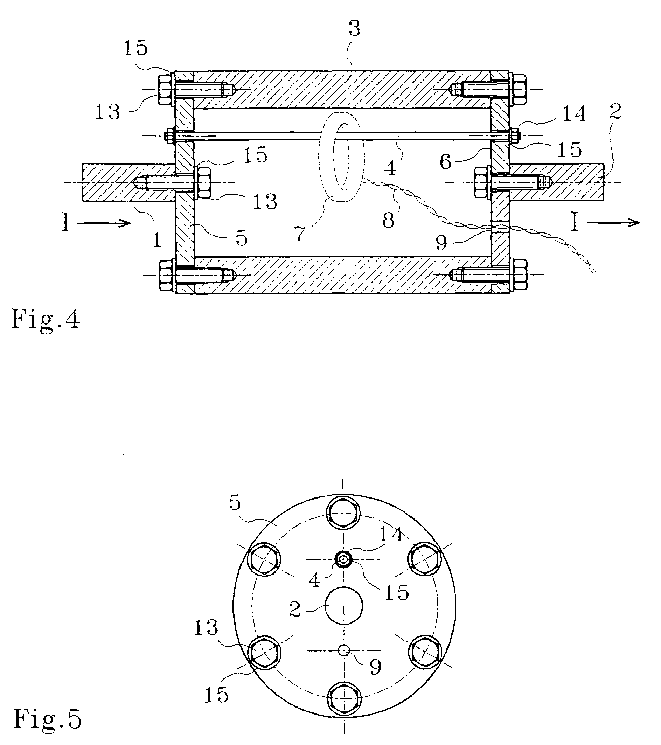

Die in Fig. 2, 3 und 4 dargestellten Ausführungsbeispiele erläutern verschiedene Montagemöglichkeiten der stromführenden Teile:

Fig. 2 zeigt einen Stromteiler, der mittels Preßverbindungen 10 und Schrumpfverbindungen 11 zusammengefügt ist. Die Kontakte 1 und 2 sind mit Bohrungen versehen, in die der Nebenstromleiter 4 eingepreßt ist. Der Hauptstromleiter 3 ist auf die Kontaktplatten 5 und 6 aufgeschrumpft. Diese sind wiederum auf die Kontakte 1 und 2 aufgeschrumpft.

Die Teile des in Fig. 3 dargestellten Stromteilers wurden mittels Schweißnähte 12 verbunden.

In Fig. 4 ist die Schraubverbindung als Montagemöglichkeit dargestellt. Die Kontakte 1 und 2 sowie der Hauptstromleiter 3 sind mit Gewindebohrungen versehen und durch Schrauben 13 mit den Kontaktplatten 5 und 6 verbunden. Der Nebenstromleiter 4 ist an den Enden mit Gewinde versehen und mit Muttern 14 an die Kontaktplatten 5 und 6 geschraubt. Zur Schonung des Materials durch Verringerung der Flächenpressung sind Unterlegscheiben 15 vorgesehen. An diesem Ausführungsbeispiel - Fig. 4 - ist zu erkennen, daß der Nebenstromleiter 4 und der Feldsensor 7 nicht koaxial zum Hauptstromleiter 3 angeordnet sind. Da das elektromagnetische Feld des Hauptstromleiters 3 an jeder Stelle innerhalb des Hauptstromleiters 3 kompensiert, d.h. praktisch nicht vorhanden, ist, besteht auch kein Grund dazu, die Bauteile innerhalb des Hauptstromleiters 3 koaxial anzuordnen.

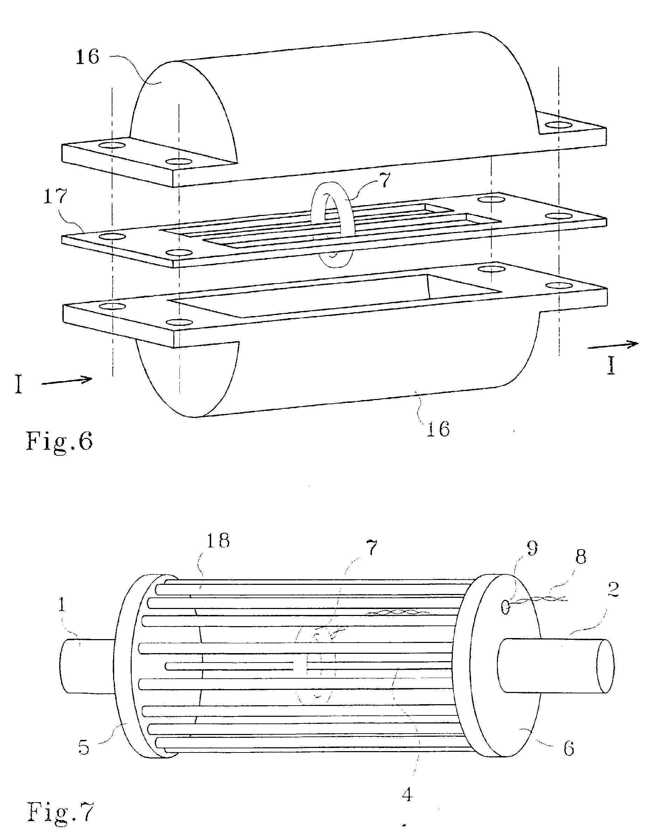

Das in Fig. 6 dargestellte Ausführungsbeispiel eines Stromteilers besteht nicht wie die bisher erläuterten aus Drehteilen, sondern aus zwei Halbschalen 16 und einer Zwischenlage 17. Der Vorteil besteht in der rationelleren Herstellung bei der Massenproduktion: Die Halbschalen 16 können als Präzisionsgußteile, beispielsweise als Aluminium-Spritzguß-Teile und die Zwischenlage 17 als Stanzteil hergestellt werden. Ein weiterer Vorteil ist die einfache Montage. Die Montageschrauben dienen gleichzeitig dem Anschluß der Zu- und Ableitung.

Ein weiteres Ausführungsbeispiel zeigt, daß der Hauptstromleiter nicht geschlossen sein muß, sondern aus mehreren Einzelleitern 18 bestehen kann (Fig. 7). Für die Kompensation des elektromagnetischen Feldes des Hauptstromleiters ist es ausreichend, wenn die Bauteile des Hauptstromleiters im rechtwinkligen Querschnitt zur Stromrichtung und in Stromrichtung an jeder Stelle des Hauptstromleiters sowohl im Materialquerschnitt, als auch räumlich radialsymmetrisch verteilt sind.

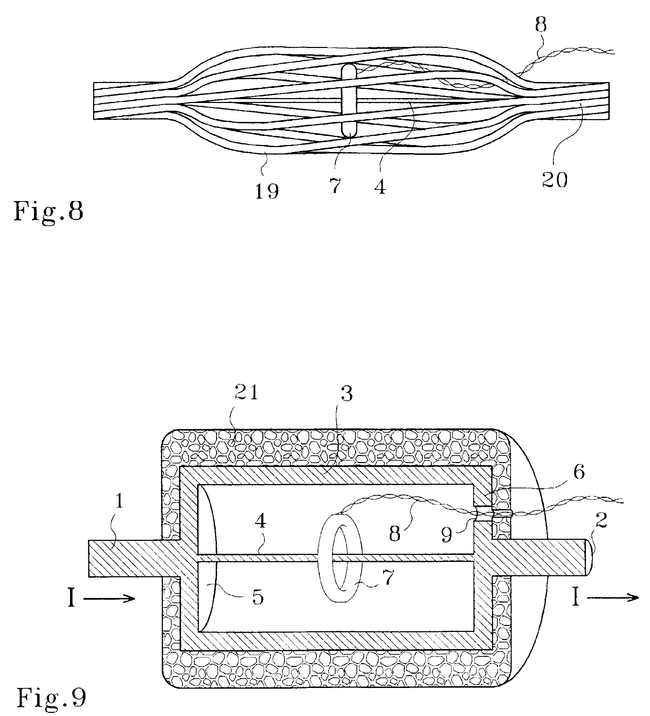

In Fig. 8 ist das Ausführungsbeispiel eines erfindungsgemäßen Stromteilers dargestellt, der ähnlich wie Leiterseile durch Verseilen einzelner Drähte 19 hergestellt wird. Dadurch ist eine einfache Integration des Stromteilers in Leiterseile 20 möglich.

Wie schon am Stand der Technik kritisiert, ist der Temperaturausgleich zwischen Hauptstromleiter 3 und Nebenstromleiter 4 von entscheidender Bedeutung für die Meßgenauigkeit von Stromteilern. Obwohl beim erfindungsgemäßen Stromteiler durch die Anordnung des Nebenstromleiters 4 im Hauptstromleiter 3 bereits gute Voraussetzungen für einen Temperaturausgleich gegeben sind, besteht die Möglichkeit, daß durch äußere Einflüsse eine Temperaturdifferenz zwischen Hauptstromleiter 3 und Nebenstromleiter 4 entsteht. Ursachen für äußere Temperatureinwirkung können benachbarte Bauteile sein, insbesondere der Stromteiler gleicher Bauart eines anderen Außenleiters bei ungleichmäßig belastetem Netz, ungleichmäßige Kühlung durch Zugluft oder auch direkte Sonneneinstrahlung. Diese Einflüsse abzubauen, ist mit folgenden Ausführungsbeispielen möglich.

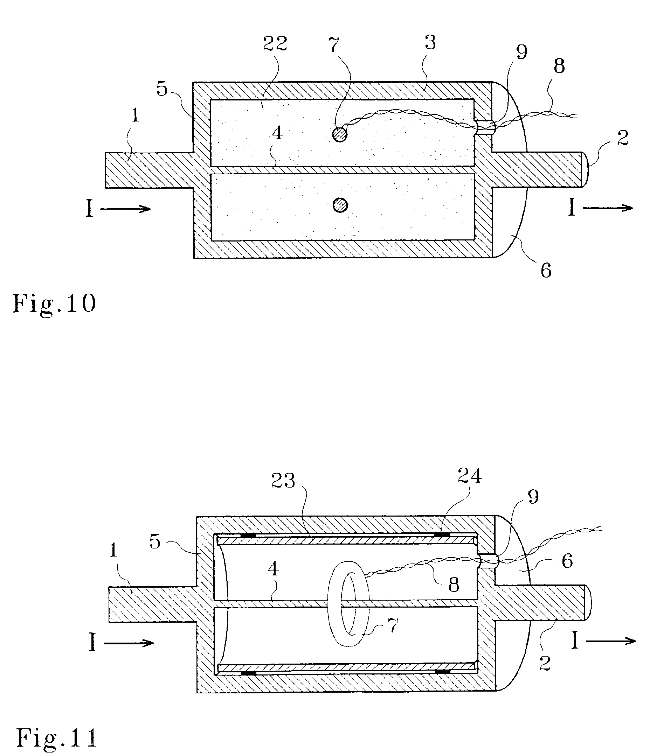

Der in Fig. 9 dargestellte Stromteiler ist allseitig mit einem wärmedämmenden Material 21, wie zum Beispiel PUR-Schaum, umgeben, das äußere Temperatureinflüsse abschwächt. Die im Hauptstromleiter 3 eingeschlossene Luft sorgt durch Konvektion für einen guten Wärmeausgleich zwischen Nebenstromleiter 4 und Hauptstromleiter 3. Dieser Wärmeausgleich wird im Ausführungsbeispiel nach Fig. 10 noch verstärkt, weil der Hohlraum zwischen Nebenstromleiter 4 und Hauptstromleiter 3 mit einem wärmeübertragenden Füllstoff 22 ausgefüllt ist. Ideal geeignet ist gasförmiger Wasserstoff weil die Konvektion wegen dessen großer Wärmekapazität besonders effektiv ist. Es kann auch ein elektrisch isolierender fester Stoff mit großer Wärmeleitfähigkeit, wie zum Beispiel Wärmeleitpaste, angewendet werden.

Wie im Wesen der Erfindung bereits erläutert, wird das elektromagnetische Feld innerhalb des Hauptstromleiters 3 allein vom Nebenstromleiter 4 verursacht. Es besteht aber die Möglichkeit, daß Störfelder von außen eindringen. Das geplante Anwendungsgebiet des erfindungsgemäßen Stromteilers sind in erster Linie Schaltanlagen in der Energiewirtschaft. Hier ist immer mit elektromagnetischen Feldern zu rechnen. Diese können sogar durch die benachbarten Stromteiler gleicher Bauart, die an andere Außenleiter angeschlossen sind, hervorgerufen werden. Deren Hauptstromleiter 3 sind von starken elektromagnetischen Feldern umgeben, da außerhalb des Hauptstromleiters 3 keine Feldkompensation erfolgt. Es gilt zu verhindern, daß elektromagnetische Störfelder von außen in den Hauptstromleiter 3 eindringen. Die elektrostatische Komponente eines Störfeldes wird bereits durch den elektrisch leitfähigen Hauptstromleiter 3 abgeschirmt. Für die Abschirmung der magnetischen Komponente wird im Ausführungsbeispiel nach Fig. 11 eine rohrförmige Hülse 23 aus ferromagnetischem Material vorgesehen, die gegenüber dem Hauptstromleiter 3 elektrisch isoliert angeordnet wird. Innerhalb dieses Ringes sind äußere elektromagnetische Störfelder abgeschirmt.

Wie bei der Kritik am Stand der Technik beschrieben, werden in bekannten Stromwandlern unterschiedliche Feldsensoren 7 angewendet. Nachfolgende Ausführungsbeispiele erläutern den erfindungsgemäßen Stromteiler in verschieden Varianten, bei denen Feldsensoren 7 mit unterschiedlicher Bauart und/oder auf verschiedenen physikalischen Wirkprinzipen beruhend zum Einsatz kommen.

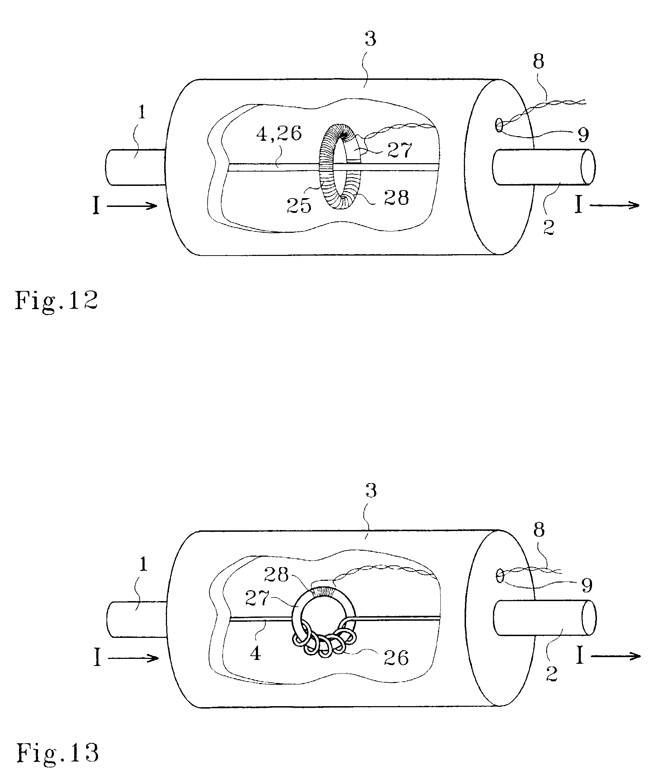

Am verbreitetsten in der Energiewirtschaft sind Stromwandler mit einer Ringkemspule 25 als Feldsensor 7. Fig. 12 zeigt eine Ringkernspule 25, eingesetzt in den erfindungsgemäßen Stromteiler. Die Ringkernspule 25 bildet zusammen mit dem Nebenstromleiter 4 einen Transformator, der in diesem Anwendungsfall als Stromwandler bezeichnet wird. Der Nebenstromleiter 4 ist die Primärwicklung 26, der ferromagnetische Ringkern 27 der Ringkernspule 25 ist der Transformatorkern und die Wicklung der Ringkernspule 25 ist die Sekundärwicklung 28, an deren Wicklungsenden die Leitung für die Signalauskopplung 8 angeschlossen ist.

In Fig. 13 wird deutlich, daß die Primärwicklung 26 eines Stromwandlers mit Ringkernspule 25 aus mehreren Windungen bestehen kann. Das wird erreicht, indem der Nebenstromleiter 4 mehrfach durch den Ringkern 27 geführt wird.

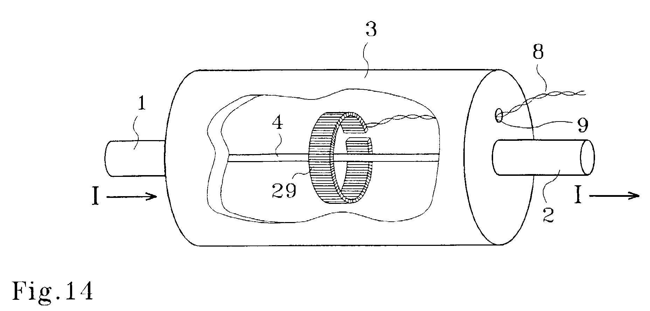

In Fig. 14 ist ein Ausführungsbeispiel des erfindungsgemäßen Stromteilers mit einer Rogowski-Spule 29 dargestellt. Es handelt sich dabei um eine offene Spule ohne ferromagnetischen Kern, die zum Ausmessen partieller elektromagnetischer Felder entwickelt wurde.

Bei den nächsten Ausführungsbeispielen werden Stromwandler angewendet, die mit elektronischen Schaltungen arbeiten. Deren Funktion kann naturgemäß leicht von elektromagnetischen Störfeldern beeinflußt werden. Für solche Stromwandler ist der erfindungsgemäße Stromteiler besonders geeignet, da bis auf das geringe Feld des Nebenstromleiters 4 innerhalb des Hauptstromleiters 3 alle anderen Felder erfindungsgemäß kompensiert und abgeschirmt sind.

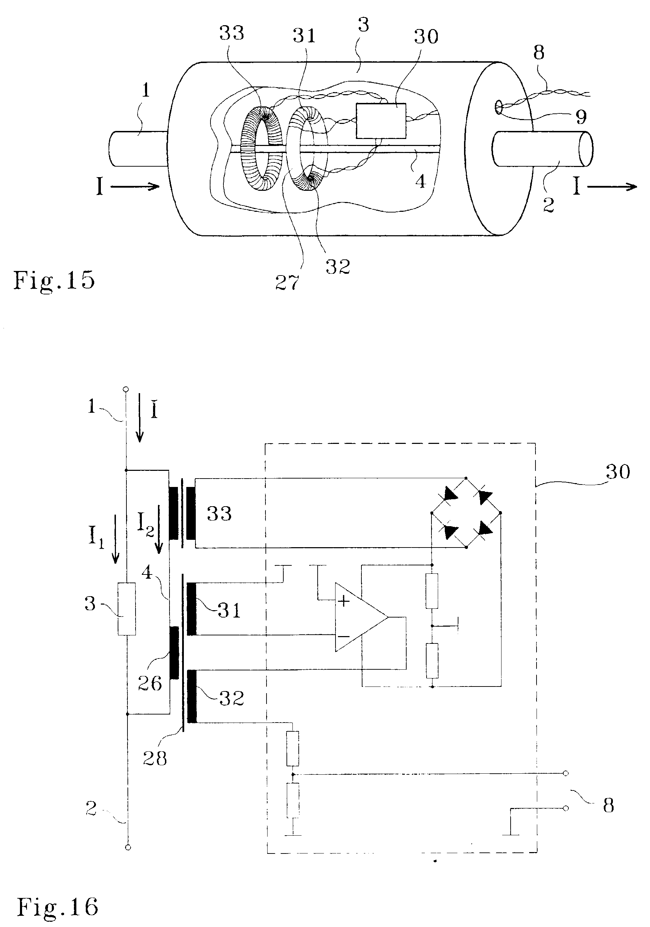

Fig. 15 und 16 zeigen einen bekannten Nullflußwandler, der komplett innerhalb des Hauptstromleiters 3 des erfindungsgemäßen Stromteilers untergebracht ist. Der Nullflußwandler arbeitet nach dem Kompensationsprinzip. Die Wirkungsweise ist folgende: Der magnetische Fluß im Ringkern 27, hervorgerufen durch die Primärwicklung 26, wird mit der Indikator-wicklung 31 erfaßt und in ein Wechselspannungssignal umgewandelt. Ein OPV verstärkt dieses Signal und speist die Kompensations-Wicklung 32 die im Ringkern 27 einen magnetischen Fluß erzeugt, der dem durch die Primärwicklung 26 entstandenen Fluß entgegengerichtet ist. Somit stellt sich unabhängig von der Stromstärke im Nebenstromleiter 4 ein Gleichgewicht ein, bei dem der magnetische Fluß im Ringkern 27 gegen Null geregelt wird. Je größer der magnetische Fluß, der durch die Primärwicklung 26 im Ringkern 27 hervorgerufen wird, desto größer stellt sich der Strom in der Kompensations-Wicklung 32 ein, um den magnetische Fluß zu kompensieren. Er ist deshalb ein Maß für den zu messenden Strom im Nebenstromleiter 4 und verursacht am Arbeitswiderstand einen Spannungsabfall, der über die Leitung 8 als Meßsignal zur Verfügung steht. Die Hilfsenergiegewinnung für den Nullflußwandler kann von außen über eine separate Stromquelle erfolgen. In diesem Ausführungsbeispiel wird die Stromversorgung von außen unabhängig mit einer Ringkernspule als Transformator 33, der den Nebenstromleiter 4 als Primärwicklung besitzt, realisiert.

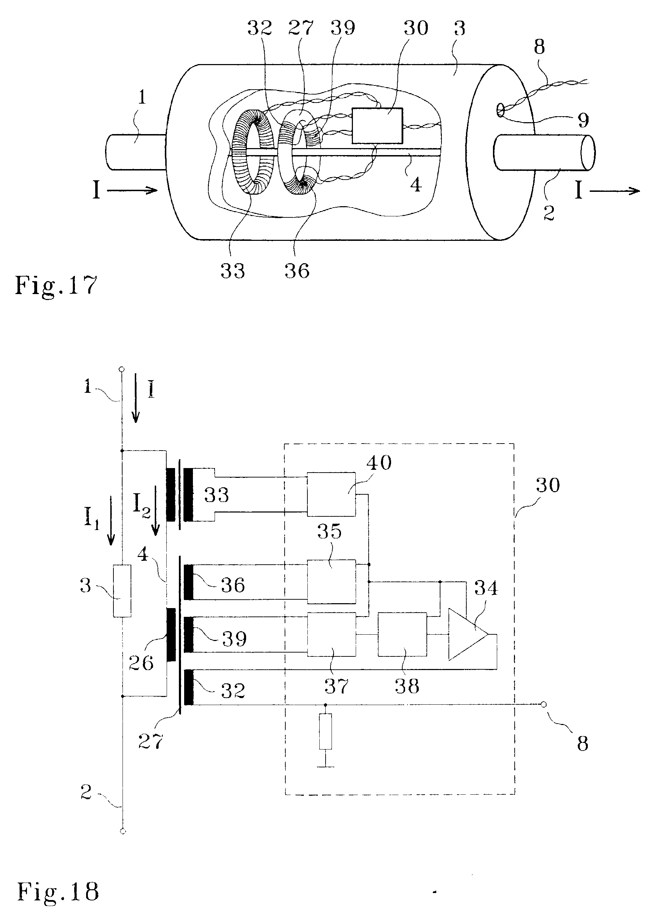

Fig. 17 und 18 zeigen den erfindungsgemäßen Stromteiler, ausgerüstet mit einem bekannten Allfrequenzstromwandler, der ebenfalls nach dem Kompensationsprinzip arbeitet, jedoch mit dem Unterschied, daß statt der Indikatorwicklung 31 ein magnetischer Modulator den magnetischen Fluß erfaßt. Der Modulator setzt sich zusammen aus Generator 35, Modulatorwicklung 36, Ringkern 27, Demodulatorwicklung 39 und Impulsaufbereitung 37 und arbeitet nach folgendem Prinzip: Der Generator 35 erzeugt eine dreieckförmige Wechselspannung, mit der die Modulatorwicklung 36 gespeist wird. Die Dimensionierung muß so erfolgen, daß der magnetische Fluß im Ringkern 27 im Sättigungsbereich liegt. Unter dieser Voraussetzung wird bei jedem Nulldurchgang des Magnetflusses ein Nadelimpuls in der Demodulatorwicklung 39 induziert. In der anschließenden Impulsaufbereitunng 37 wird eine mit den Nadelimpulsen synchronisierte Rechteck-Wechselspannung erzeugt. Wenn im Ringkern 27 ein magnetischer Fluß entsteht, hervorgerufen durch den zu messenden Strom im Nebenstromleiter 4 - gleichbedeutend mit der Primärwicklung 26 -, verschieben sich die Nulldurchgänge bezogen auf den dreieckförmigen Wechselfluß um den Betrag des durch die Primärwicklung 26 verursachten Magnetfluß. Da der Magnetfluß, der durch die Modulatorwicklung 36 hervorgerufen wird, einen dreieckförmigen Verlauf besitzt, verschieben sich die Nulldurchgänge auf der Zeitachse im selben Verhältnis gegeneinander. Dementsprechend ändert sich das Tastverhältnis der Rechteck-Wechselspannung. Der magnetische Modulator erzeugt somit eine mit der zu messenden Stromstärke pulsweitenmoduliertes Rechteck-Wechselspannungssignal. Dieses wird im anschließenden Demodulator 38 demoduliert und mit dem so entstandenen analogen Spannungssignal die Kompensatorschaltung angesteuert, deren Funktion bereits im Ausführungsbeispiel nach Fig. 15 und 16 erläutert wurde. Die Stromversorgung der einzelnen Baugruppen erfolgt entweder extern oder mittels Ringkernspule 33 mit nachfolgender Spannungsaufbereitung 40.

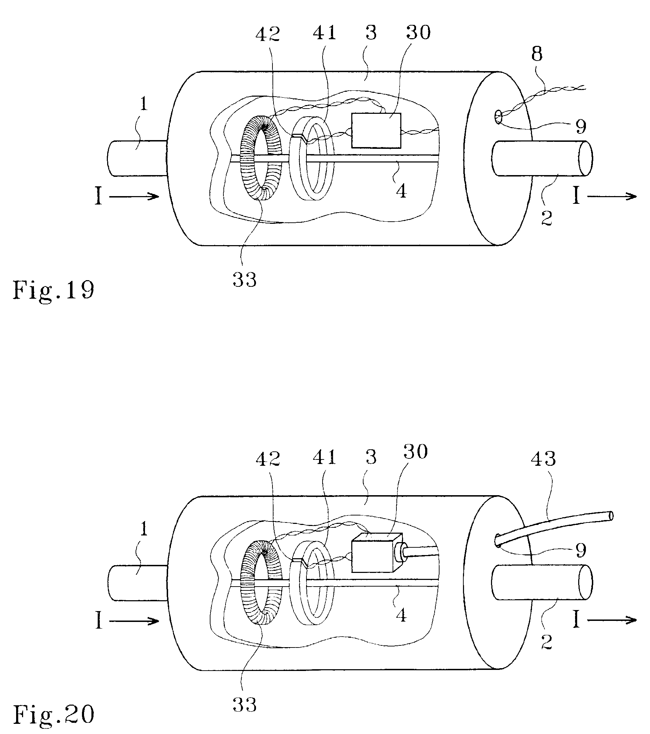

Ein anderes Meßprinzip wird im Ausführungsbeispiel nach Fig. 19 beschrieben. Der Feldsensor ist im Aufbau bekannt und besteht aus einem mit einem Spalt unterbrochenen ferromagnetischem Ring 41 der die Aufgabe hat, den magnetischen Fluß im Spalt durch Bündeln der Magnetlinien zu verstärken und einem Hall-Element 42, das im Spalt angeordnet ist und den zum Strom im Nebenstromleiter 4 proportionalen Magnetfluß erfaßt. Die Stromversorgung und Signalaufbereitung für das Hall-Element 42 erfolgen in bekannter Weise mit der nicht näher beschriebenen elektronischen Schaltung im Gehäuse 30, die ihrerseits entweder extern oder mittels Ringkernspule 33 mit Strom versorgt wird.

Fig. 20 zeigt ein Ausführungsbeispiel, bei dem das Meßsignal nicht als elektrisches Signal über eine Leitung 8 ausgekoppelt, sondern mit einer im Gehäuse 30 enthaltenen, bekannten und nicht näher beschriebenen elektronischen Schaltung in ein optisches Signal umgewandelt und über einen Lichtwellenleiter 43 ausgekoppelt wird. Die Stromversorgung erfolgt über eine Ringkernspule 33.

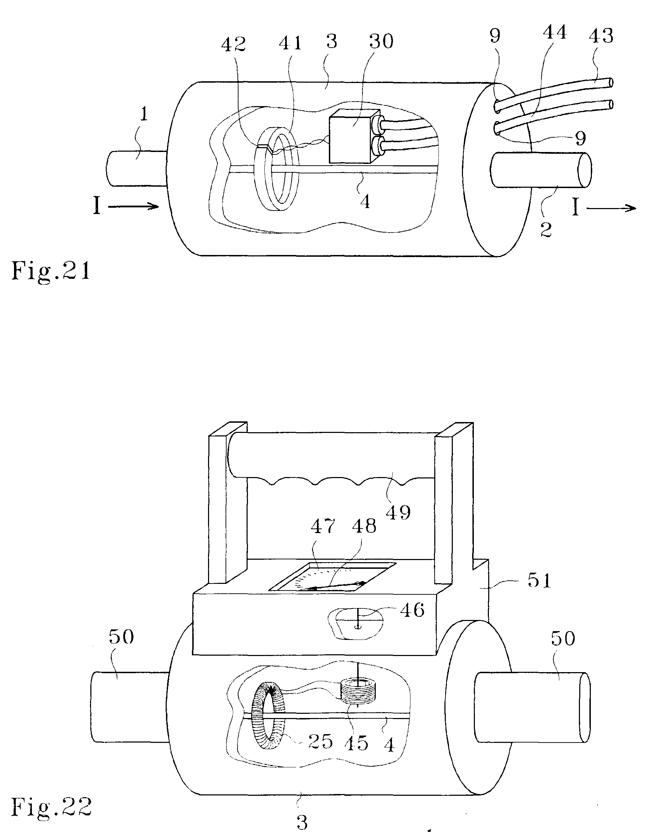

Im Ausführungsbeispiel nach Fig. 21 wird die Energieversorgung der elektronischen Schaltung mit Lichtenergie realisiert. Dazu wird entweder der selbe Lichtwellenleiter wie für die Signalauskopplung 43 genutzt, oder ein separater Lichtwellenleiter für die Energieversorgung 44 angeordnet.

Der Vorteil der beiden letztgenannten Anwendungsbeispiele besteht darin, daß das Meßsignal potentialfrei ausgekoppelt werden kann, wodurch ein problemloser Einsatz in der Hochspannungstechnik möglich ist.

Das Ausführungsbeispiel nach Fig. 22 stellt einen erfindungsgemäßen Stromteiler als Handmeßgerät in Form einer Niederspannungs-Hochleistungs-Sicherung (NH-Sicherung) dar. Der Hauptstromleiter 3 bildet das Gehäuse, an dem stirnseitig die Messerkontakte 50 angebracht sind. Der Stromwandler, bestehend aus dem Nebenstromleiter 4 und der Ringkernspule 25, wird in bekannter Weise mit der Spule des Meßwerkes 45 im Kurzschluß betrieben. Das Meßwerk ist über die nichtmetallische Achse 46 mit dem Zeiger 48 verbunden, der den Meßwert auf der Skala 47 in analoger Form anzeigt. Als Träger für die Skala 47 und den Handgriff 49 dient der Gehäuseaufsatz 51 aus elektrisch isolierendem Material.

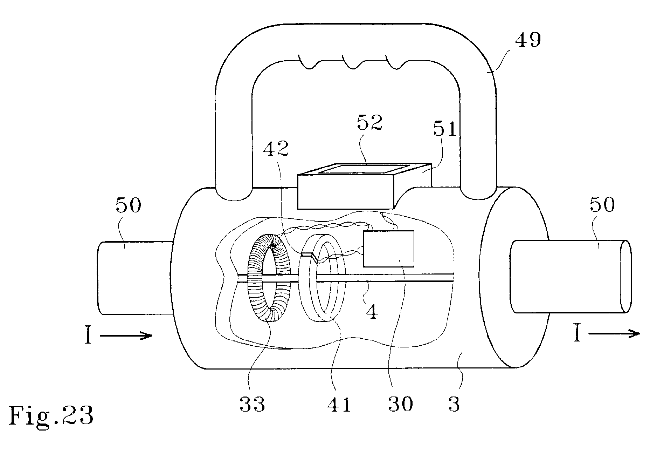

Das Ausführungsbeispiel nach Fig. 23 zeigt ebenfalls ein in Form einer NH-Sicherung ausgebildetes Handmeßgerät basierend auf dem erfindungsgemäßen Stromteiler. Der Unterschied zum Ausführungsbeispiel nach Fig. 22 besteht darin, daß das Signal des Feldsensors, in diesem Beispiel wurde ein Hall-Element entsprechend dem Ausführungsbeispiel nach Fig. 22 ausgewählt, mittels einer bekannten nicht näher beschriebenen elektronischen Auswerteschaltung im Gehäuse 30 aufbereitet und im Display 52 in digitaler Form angezeigt wird. Das Display besteht vorzugsweise aus einer mehrstelligen 7-Segment-Anzeige mit LCD- oder LED-Elementen. Die Spannungsversorgung erfolgt entweder aus nicht dargestellten Primärelementen oder Akkumulatoren oder mittels Ringkerntrafo 33.

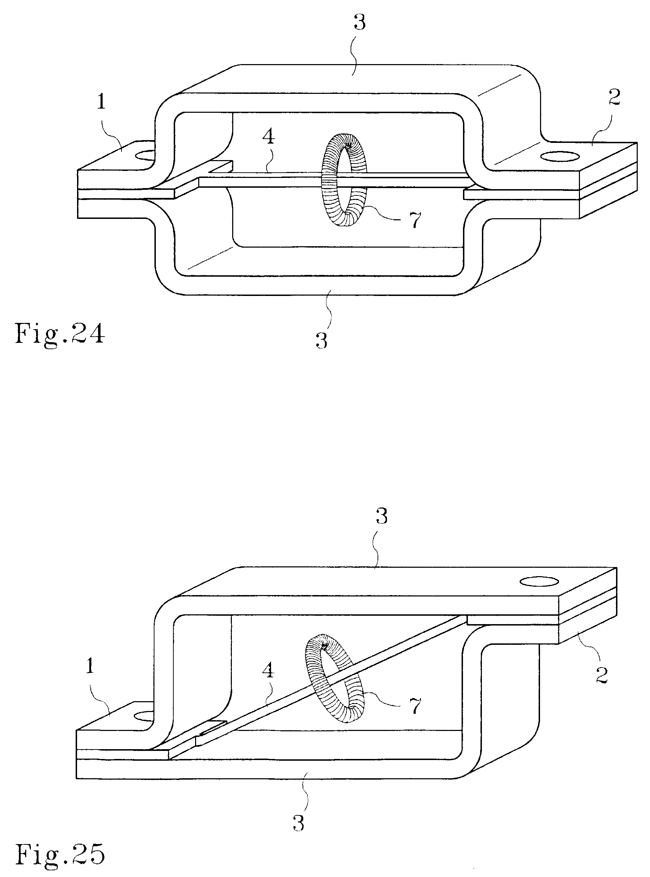

In Fig. 24 ist ein Ausführungsbeispiel des erfindungsgemäßen Stromteilers dargestellt, dessen Hauptstromleiter 3 aus zwei zweifach gekröpften Metallteilen besteht. Diese lassen sich vorteilhaft aus entsprechenden Flachband-Halbzeugen mittels Kantpressen herstellen. Der Nebenstromleiter 4 kann in einem Arbeitsgang durch Stanzen angefertigt werden. Die Montage des Stromteilers erfordert ebenfalls wenig Aufwand. Die Einzelteile werden mit Schrauben verbunden, mit denen gleichzeitig die Zuleitungen angeschlossen werden.

Der in Fig. 25 dargestellte Stromteiler ist ähnlich aufgebaut wie der vorhergehende, jedoch mit dem Unterschied, daß die Metallteile, aus denen der Hauptstromleiter besteht, nur jeweils einmal gekröpft sind. Der Nebenstromleiter 4 ist an zwei Stellen abgewinkelt.

## Patentansprüche

1. Stromteiler für Meßwandler in kompakter Bauform für die Umwandlung großer Ströme in meßbare kleinere Ströme**, dadurch gekennzeichnet**, daß der Stromteiler aus einem Hauptstromleiter (3) besteht, der einen mit einem Feldsensor (7) ausgestatteten Nebenstromleiter (4) umgibt, wobei der Hauptstromleiter (3) in seinem senkrecht zur Stromrichtung liegenden Querschnitt radialsymmetrisch ausgebildet ist, und der Hauptstromleiter (3) und der Nebenstromleiter (4) sowohl an der Stromeintrittsseite des Stromteilers als auch an dessen Stromaustrittsseite elektrisch leitfähig miteinander verbunden sind und an diesen Stellen Anschlußkontakte (1, 2) zum Zu- und Abführen des zu messenden Stromes aufweisen.

2. Stromteiler nach Anspruch 1, dadurch gekennzeichnet, daß der Hauptstromleiter (3) die Form eines Hohlzylinders aufweist, der zu beiden Seiten durch Kontaktplatten (5, 6) elektrisch leitfähig verschlossen ist, wobei der Nebenstromleiter (4) von der Innenseite der einen Kontaktplatte (5) zur Innenseite der gegenüberliegenden Kontaktplatte (6) geführt ist und die Kontaktplatten (5, 6) an ihren Außenseiten die Anschlußkontakte (1, 2) aufweisen.

3. Stromteiler nach Anspruch 1, dadurch gekennzeichnet, daß der Hauptstromleiter (3) aus einer Vielzahl von Einzelleitern besteht.

4. Stromteiler nach Anspruch 1 bis 3, dadurch gekennzeichnet, daß neben dem Nebenstromleiter (4) und dem diesem zugeordneten Feldsensor (7) auch die das Signal des Feldsensors (7) aufbereitende Meßelektronik (30) vom Hauptstromleiter (3) umgeben ist.

5. Stromteiler nach Anspruch 1 und 4, dadurch gekennzeichnet, daß um den Nebenstromleiter (4) eine Ringkernspule (33) für die Spannungsversorgung der Meßelektronik (30) angeordnet ist.

6. Stromteiler nach Anspruch 1 bis 3, dadurch gekennzeichnet, daß der Stromteiler vollständig oder teilweise von einem wärmedämmenden Material (21) umgeben ist.

7. Stromteiler nach Anspruch 1 bis 3, dadurch gekennzeichnet, daß der Raum zwischen dem Hauptstromleiter (3) und dem Nebenstromleiter (4) vollständig oder teilweise mit wärmeleitfähigem, elektrisch isolierendem Material (22) ausgefüllt ist.

8. Stromteiler nach Anspruch 1 bis 3, dadurch gekennzeichnet, daß innerhalb des Hauptstromleiters (3) eine gegenüber dem Hauptstromleiter (3) elektrisch isolierte, den Nebenstromleiter (4), den Feldsensor (7) und die Meßelektronik (30) umgebende Hülse (23) aus ferromagnetischem Material angeordnet ist.

9. Stromteiler für Meßwandler in kompakter Bauform für die Umwandlung großer Ströme in meßbare kleinere Ströme**, dadurch gekennzeichnet**, daß sich der Stromteiler als Handmeßgerät in Form einer Niederspannungs-Hochleistungs-Sicherung darstellt, wobei der als Gerätegehäuse ausgebildete Hauptstromleiter (3) einen mit einem als Ringspule (25) ausgebildeten Feldsensor ausgestatteten Nebenstromleiter (4) umgibt, und der Hauptstromleiter (3) in seinem senkrecht zur Stromrichtung liegenden Querschnitt radialsymmetrisch ausgebildet ist, der Hauptstromleiter (3) und der Nebenstromleiter (4) sowohl an der Stromeintrittsseite des Stromteilers als auch an dessen Stromaustrittsseite elektrisch direkt leitfähig miteinander verbunden sind und an diesen Stellen Messerkontakte (50) zum Zu- und Abführen des zu messenden Stromes aufweisen , wobei der Ringspule (25) eine innerhalb des Hauptstromleiters (3) befindliche Spule eines Meßwerkes (45) zugeordnet ist, die über eine nichtmetallische Achse (46) mit einer aus Zeiger (48) und Skala (47) bestehenden, in einem Gehäuseaufsatz (51) angeordneten Anzeige in Wirkverbindung steht, wobei der Gehäuseaufsatz (51) und ein darin integrierter Handgriff (49) gegenüber dem Gerätegehäuse elektrisch isoliert ist.
